# EUROPEAN PATENT APPLICATION

(11) **EP 0 777 259 A1**
(43) Date of publication of application: **04.06.1997**
(21) Application number: 96308627.7
(22) Date of filing: 28.11.1996
(51) Int. Cl.: H01J 37/32

(54) **Apparatus for delivering fluid to a point of use location**

(30) Priority: 29.11.1995 US 564466
(71) Applicant: APPLIED MATERIALS, INC., Santa Clara, California 95054-3299 (US)
(72) Inventor: Manofsky, William L., Jr., San Jose (US); Kaczorowski, Edward M., Saratoga, California 95070 (US)
(74) Representative: Bayliss, Geoffrey Cyril

(57) **Abstract**

The disclosure relates to a fluid or gas delivery assembly utilizing flat bottom components. In one embodiment the assembly includes a valve (20) comprising inlet and outlet ports (32,33) disposed along a flat, planar surface (26). The valve is attached to a manifold (50) having passages (52,55,56) for interconnecting the valve with other fluid system components. The manifold comprises at least one flat outside surface (103) to facilitate the attachment of the valve to the manifold. The flat surface of the manifold consists of inlet and outlet ports (55,56) corresponding to the inlet and outlet ports (32,33) of the valve. The flat outside surface of the manifold also includes threaded openings (46) that correspond to openings disposed in the flat, planar surface (26) of the valve. The valve is attached to the manifold by placing the valve over the flat outside surface of the manifold and aligning their respective inlet and outlet ports. Once aligned, the valve is fixedly attached to the manifold by inserting threaded fasteners into the valve openings and engaging the fasteners with the threaded openings of the manifold such that a fluid seal is established between the flat, planar surface of the valve and the flat outside surface of the manifold.

## Description

The present invention relates generally to fluid and gas systems. More particularly, the invention relates to a fluid or gas system which includes flat bottom components, such as, for example, valves, regulators, instrumentation devices, etc.

It is known that in many industrial processes it is necessary to control the flow of fluids and process gases. The fluids and gases, in many instances, may be either toxic or corrosive, or both. In many industries, including the semiconductor, pharmaceutical and nuclear industries, to name a few, process gases and fluids delivered to point-of-use locations must be of high purity and must be particle free. In order to illustrate the need for systems that are capable of delivering highly pure and particle free gases and fluids, this discussion will mainly be limited to those needs associated with semiconductor processing. It will be recognized, however, that such focus is for descriptive purposes only and that the apparatus of the present invention are applicable to any gas or fluid delivery system.

As previously discussed, the provision of high purity gas and fluid streams are critically important in a wide variety of industrial applications. For example, the rapid expansion of chemical vapor deposition and etching techniques in the semiconductor industry has been associated with the deployment and use of manufacturing equipment that is totally reliant on the delivery of ultra-high purity process gases at the point of use in the semiconductor manufacturing facility. For high purity gas operations, it is essential that the process gases be delivered to the point of use with minimum contamination since even parts-per-billion impurity levels can adversely effect the efficiency of semiconductor and other high purity products. In addition, it is necessary to assure that the gas delivery system is capable of operating safely and without gas leakage that could jeopardize the health and safety of system operators.

Conventional gas delivery systems commonly use stainless steel alloy tubing and compression fittings to supply the interconnections between a variety of system components, such as valves, regulators, and pressure sensors. In addition, to adapt the system components to the system tubing, portions of tubing must first be welded to the system components before they are capable of being interconnected by the fittings. Although the use of conventional tubing systems is well established, there are many problems associated with their use. These problems are further accentuated in systems requiring the delivery of toxic or corrosive gases and fluids at high purity levels.

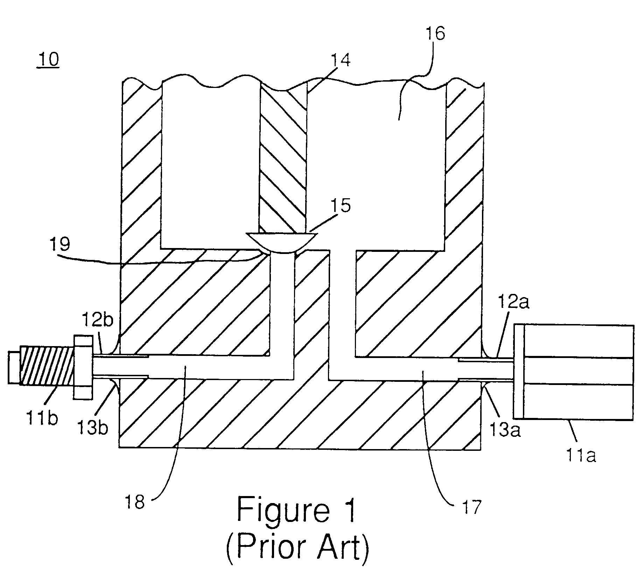

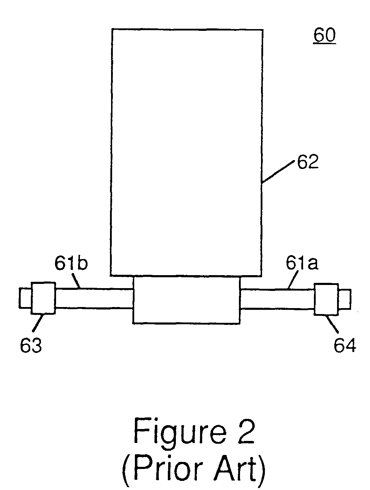

As previously discussed, conventional tubing systems utilize fittings and welds to provide the interconnection between system components. These complex systems of tubing, fittings and welds present a number of problems. Each component in a conventional tubing system typically requires at least two fittings, and, in many cases, contains welded joints at the component and tubing interface. As an example, Figure 1 illustrates a cross-sectional view of the lower body section 10 of a typical prior art valve that is used in conventional fluid and gas delivery systems. As shown in Figure 1, the valve body 10 contains an inlet passage 17 and an outlet passage 18 leading into and out of a cavity 16 disposed within valve body 10. The valve includes a disk 15 that is attached to a stem 14 that is used to forcibly engage the disk 15 against a valve seat 19. More importantly, it should be noted that the valve body 10 includes fittings 11a and 11b that are attached via tubing sections 12a and 12b and welds 13a and 13b. Figure 2 illustrates yet another example of a prior art component used in conventional fluid and gas delivery systems. Figure 2 illustrates a side view of a typical prior art instrumentation measurement device 60. As illustrated, device 60 contains a body 62 and tubing sections 61a and 61b. Similar to the valve body previously discussed, device 60 includes fittings 63 and 64 that are necessary for connecting the device to other system components. It is to be appreciated that the costs associated with utilizing fittings and welds to make the interconnection between system components are high and result in increased manufacturing costs. In addition, it is understood that tubing and fitting assemblies are prone to leakage from improper assembly, service, or damage during use.

Yet another problem associated with conventional tubing systems is their susceptibility to contamination. As mentioned earlier, many tubing assemblies require welds to form the connections between the system components and tubing. These welds are highly susceptible to pitting and crevice corrosion, especially in those systems delivering corrosive media. It is readily understood that corrosion leads to increased contamination. Note also, that in tubing assemblies the wetted surface area exposed to the fluid flowing through the system is relatively large. This, too, can lead to increased impurities within the system. As noted earlier, in some applications, such as ultra-clean semiconductor applications, the delivery of high purity gas streams is critically important. For example, the growth of high quality thin film electronic and opto-electronic cells by chemical vapor deposition or other vapor based techniques is inhibited by impurities within the gas delivery system. These impurities can cause defects that reduce yields by increasing the number of rejects, which can be very expensive.

It is also important to note that conventional tubing systems typically require an in-line configuration. That is, each system component must be successively connected to one another along a single line of tubing. This restriction makes it difficult to miniaturize the design of such systems, thus, resulting in larger and bulkier assemblies. Moreover, this restriction results in larger intemal gas volumes that necessitate larger purge times, with an excess waste of costly purge gases.

What is needed then is an apparatus which solves the problems associated with delivering gases and fluids to point-of-use locations. As will be seen, the present invention provides improved components and an improved gas and/or fluid delivery system which solves the aforementioned problems by utilizing a flat bottom component architecture.

An improved valve and fluid delivery assembly is disclosed. In one embodiment, the present invention comprises a valve possessing a flat, planar surface for interfacing with other components in a fluid or gas delivery system. The flat, planar surface of the valve includes an inlet and outlet port and a plurality of openings disposed along its outer edges. Typically, threaded fasteners are disposed within openings located along the outer edges of the valve for fixedly attaching the valve to other components. The inlet port permits a fluid flow into the cavity of the valve through an inlet passage disposed within the body of the valve. The outlet port defines the exit point of an outlet passage that is also disposed within the valve body. The outlet passage permits a fluid flow out of the valve cavity. One of the salient features of the present invention is that the valve may be attached to other components within a fluid system without the use of fittings or welds.

In another embodiment of the present invention flat bottom valves and/or other types of flat bottom components, such as, for example, instrumentation devices, are attached to a monolithic structure having passages for interconnecting the flat bottom components. The monolithic structure generally consists of a manifold having at least one flat outside surface to facilitate the attachment of the flat bottom components to the manifold. The flat outside surfaces of the manifold typically consists of inlet and/or outlet ports corresponding to the inlet and/or outlet ports of the flat bottom components to be attached to the manifold. In addition, the flat outside surfaces of the manifold include threaded openings that correspond to openings disposed about the outer edges of the flat bottom components. The flat bottom components are typically attached to the manifold by first placing the flat component over the flat outside surface of the manifold and aligning their respective inlet and/or outlet ports. Once aligned, the flat bottom components are fixedly attached to the manifold by inserting threaded fasteners into the respective component openings and engaging the fasteners with the threaded openings of the manifold.

In yet another embodiment, the present invention includes a valve body assembly comprising a cavity, a valve element, means for positioning the valve element, and a flanged section having a planar face. The valve body assembly is attached to another fluid system component containing inlet and outlet passages wherein the passages have openings disposed along at least one planar outside surface. When the valve body assembly and fluid component are attached along their planar surfaces, the valve element is positioned to engage with either the inlet or outlet opening of the fluid component to permit or restrict a fluid flow through the respective passage.

The present invention is characterized by its simple construction and its relatively low cost. Since the need for fittings and welds is greatly diminished so is the costs. Reducing the number of fittings and welds also minimizes the likelihood of leakage and reduces the fluid system's susceptibility to contamination and corrosion. In addition, because the flat bottom components are capable of being attached in a variety of configurations along one or more manifold surfaces, it is possible to design and fabricate smaller and more compact fluid delivery systems.

The present invention is illustrated by way of example and is not limited by the figures of the accompanying drawings, in which like references indicate similar elements, and in which:

**Figure 1** illustrates a prior art valve containing VCR fittings and welds.

**Figure 2** illustrates a prior art instrumentation device having VCR fittings.

**Figure 3** illustrates a cross-sectional view of a flat bottom valve in one embodiment of the present invention.

**Figure 4** illustrates a bottom view of one embodiment of the valve illustrated in Figure 3.

**Figure 5** illustrates a bottom view of another embodiment of the valve illustrated in Figure 3.

**Figure 6** illustrates a cross-sectional view of another embodiment of the present invention wherein the valve of Figure 4 is attached to a manifold.

**Figure 7** illustrates a cross-sectional view of another embodiment of the present invention wherein the valve of Figure 5 is attached to a manifold.

**Figure 8** illustrates a top view of the manifold illustrated in Figure 7.

**Figure 9** illustrates a cross-sectional view of another embodiment of the present invention wherein the valve of Figure 4 is attached to the manifold of Figure 8.

**Figure 10** illustrates a cross-sectional view of another embodiment of the present invention.

**Figure 11** illustrates a cross-sectional view of another embodiment of the present invention.

**Figure 12** illustrates a side view of an instrumentation device of the present invention having a flat bottom surface.

**Figure 13** illustrates a bottom view of the device illustrated in Figure 12.

**Figure 14** illustrates a cross-sectional view of another embodiment of the present invention wherein the flat bottom device of Figure 9 is attached to a manifold.

**Figure 15** illustrates a fluid delivery system utilizing the flat bottom architecture of the present invention.

**Figure 16a** illustrates a non-planar mating surface configuration that may be used in implementing the present invention.

**Figure 16b** illustrates another non-planar mating surface configuration that may be used in implementing the present invention.

An improved valve and system that utilizes a flat bottom architecture is described. In the following description, numerous specific details are set forth, such as material types, dimensions, etc., in order to provide a thorough understanding of the present invention. However, it will be obvious to one of ordinary skill in the art that the invention may be practiced without these specific details. In other instances, well-known structures and processing steps have not been shown in particular detail in order to avoid unnecessarily obscuring the present invention. Additionally, it should be noted that throughout this discussion reference will be made to a variety of components in a fluid delivery system. For the purposes of this discussion, and, any preceding discussion made herewith, the term "fluid" includes any gas, liquid, or other media that is capable of flowing through a pipe system.

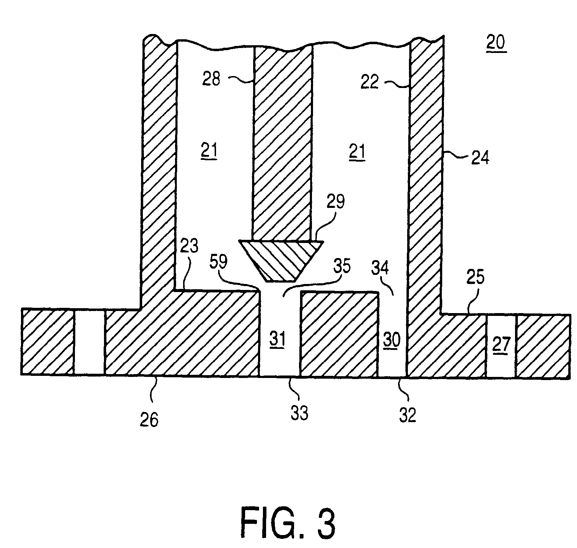

With reference to Figure 3, a cross-sectional side view of the lower body section of a flat bottom valve in one embodiment of the present invention is shown. As illustrated in Figure 3, the valve body 20 defines a cavity 21 having side walls 22 and bottom wall 23. Valve body 20 further defines an inlet passage 30 and an outlet passage 31. The inlet and outlet passages communicate with cavity 21 at an inlet port 34 and an outlet port 35 disposed along bottom wall 23. Outlet port 35 is circumscribed by a valve seat 59 for receiving a valve element 29. Valve element 29 is attached to a stem 28 that is used to forcibly engage the valve element against valve seat 59. The outer surface of valve body 20 is defined by surfaces 24, 25 and 26. As shown in Figure 3, inlet and outlet passages 30 and 31 have openings 32 and 33 disposed along surface 26, respectively. Also disposed along surface 26 are through openings 27 which are typically provided to accommodate the means for securing the valve body 20 to other components within a fluid delivery system.

As previously discussed, and as illustrated in Figure 1, a valve in a conventional fluid delivery system generally requires a complex series of tubing, fittings and welds to provide the interconnection between the valve and other system components. The problems associated with these prior art connection means are well known. One of the salient features of the present invention is that the valve may be attached to other components within a fluid system without the use of fittings or welds.

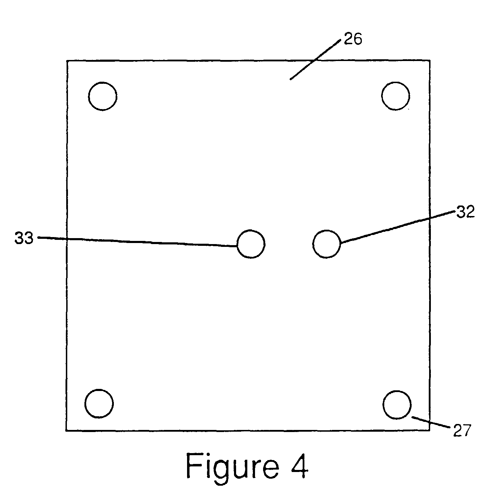

Referring now to Figure 4, a bottom view of the assembly depicted in Figure 3 is shown. As noted above, the valve body of the present invention possesses a flat bottom surface 26 containing inlet and outlet openings 32 and 33, and through holes 27. Flat bottom surface 26 allows valve body 20 to be attached to a second system component (not shown) having a flat surface with corresponding openings that communicate with openings 32 and 33. The second system component may also possess threaded openings that correspond to through openings 27. The valve body of the present invention is attached to a second system component by first aligning openings 32, 33 and 27 with corresponding openings disposed within a flat surface of the second component. Once aligned, the valve body is fixedly attached to the second system component by inserting threaded fasteners (not shown) into through holes 27 and engaging the fasteners with the threaded openings disposed along the flat surface of the second component. In one embodiment, a gasket is disposed between the flat surface of the second component and flat bottom surface 26 for sealing the interface between the two parts. In yet another embodiment, a metal limiter containing a metal sealing ring is disposed between the two surfaces to seal the interface. It is should be understood that when such sealing methods are employed that the flat surfaces of the valve and second component will not make intimate contact with themselves. Instead, the two flat surfaces will each make intimate contact with opposing sides of the gasket or limiter sealing device.

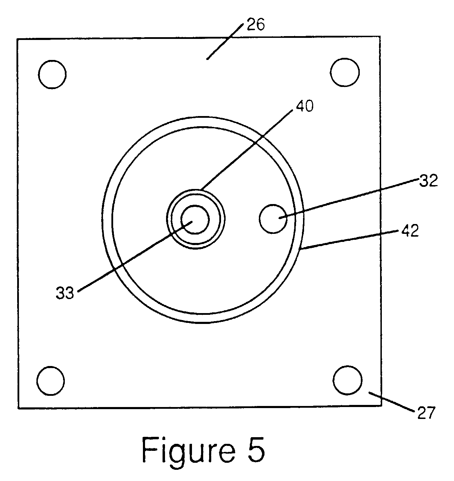

With reference to Figure 5, another embodiment of the valve assembly illustrated in Figure 3 is shown. As shown in Figure 5, flat bottom surface 26 comprises a first recess 40 disposed about outlet opening 33 and a second recess 42 enclosing both inlet and outlet openings 32 and 33. In accordance with the present invention, an o-ring, or other similar device (not shown) is disposed within each of recesses 40 and 42 to provide a seal at the flat bottom surface interface when the valve is attached to another component. It is appreciated that the recess and sealing arrangement just described is only illustrative of one possible configuration. For example, in lieu of recess 42, surface 26 may possess a second recess which is individually disposed about opening 32. It is further understood that the sealing device may comprise any material that is capable of forming a seal at the valve and component interface. By way of example the sealing device may comprise a polymer or metal material.

in the foregoing description a valve is described having a body with a flat bottom surface. It is to be understood that valve element 29, stem 28, and valve seat 59 are descriptive of only one embodiment of the present invention. Practitioners in the art will appreciate that a multitude of other valve element, valve seat and engagement designs may be used in implementing the invention. By way of example, in lieu of integrally forming valve seat 59 within outlet port 35, a polymer or metal valve seat insert may be disposed within outlet port 35. In addition, it is understood that the size, shape and structure of valve element 29 may vary depending upon the particular use or application. In one application the valve element may take upon a more elongated shape while in yet another application the valve element may comprise a diaphragm. The means for engaging the valve element against the valve seat may also vary. Although a stem is illustrated in Figure 3, a spring, air pressure, solenoid, or any of a number of other methods or devices, may be used in the implementation of the present invention. Moreover, it is noted that the fluid flow into and out of the valve assembly shown in Figure 3 may be reversed whereby fluid flows into valve cavity 21 through passage 31 and out of the cavity through passage 30. Pursuant to the preceding discussion, it is obvious that the valve of the present invention may take on many forms. For instance, the valve may comprise a regulator, a mass flow controller, etc.

In one embodiment, the entire valve assembly as depicted in Figures 3, 4, and 5 comprises stainless steel or inconel. Note, however, that any of a number of other metals, ceramics, etc. may be used depending upon the application and particular use of the valve. The shape and size of inlet and outlet passages 30 and 31 will also vary depending upon the particular application. In one embodiment passage 30 and 31 have a substantially circular cross-section with a diameter of approximately 0.15 inches. Through hole openings 27 also possess substantially circular cross-sections with diameters of approximately 0.2 inches. With continuing reference to Figures 4 and 5, flat bottom surface 26 is shown having a rectangular cross-section. In one embodiment surface 26 has a length and width of approximately 1.50 inches, respectively. The flatness and surface finish of surface 26 is dependent upon the particular sealing method employed at the valve and fluid delivery system interface. Generally, the flatness of surface 26 is controlled to approximately between 0.005 and 0.001 inches, wherein the surface finish is typically held to a 16 RA (Roughness Average) finish or better. In one embodiment, recesses 40 and 42, as illustrated in Figure 5, have a substantially circular-cross-section with a depth of 0.05 inches a width of approximately 0.15 and 0.20 inches, respectively. Surface 26 is prepared by milling the surface to a flatness of approximately between 0.005 to 0.001 inches. If required, a lapping or electropolishing process may then be used to achieve the desired surface finish. Recesses 40 and 42 are also formed using a milling process.

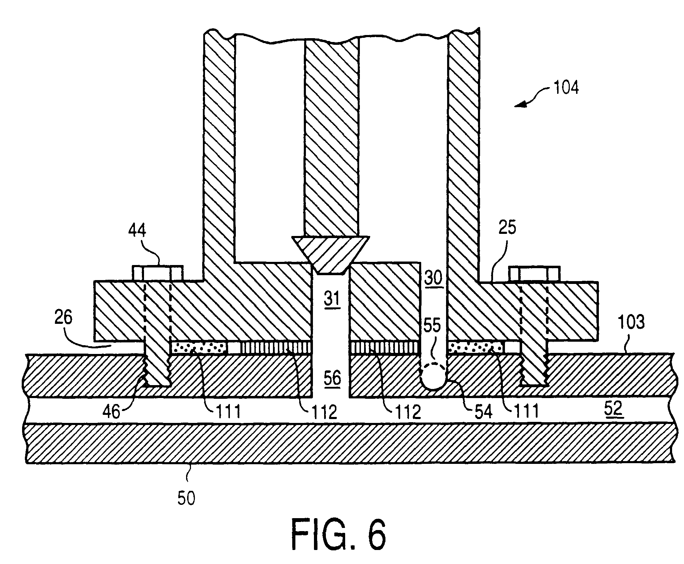

With reference to Figure 6, one embodiment of the present invention is shown wherein the flat bottom valve illustrated in Figures 3 and 4 is shown attached to a manifold 50 having a flat outside surface 103. As illustrated, manifold 50 includes a fluid passage 52 and inlet and outlet passages 55 and 56 that communicate with the inlet and outlet passages 30 and 31 of valve assembly 104. Manifold inlet passage 55 contains a through opening 54 extending through the width of manifold 50 that directs a fluid flow into the manifold. Manifold 50 also comprises threaded openings 46 disposed along flat outside surface 103. The valve assembly 104 and manifold 50 are attached by threaded fasteners 44. Sealing devices 111 and 112, are disposed between surfaces 26 and 103 to form a seal at the valve/manifold interface when the two assemblies are attached. Sealing devices 111 and 112 may comprise a gasket, metal limiter containing a sealing device, or any other similar device capable of forming a seal at the valve assembly and manifold interface. For instance, polymer gaskets are well-suited for systems delivering a non-corrosive, low temperature liquid, while metal gaskets are more appropriately used in high temperature, high pressure, corrosive applications. It is noted, that the manifold opening and surface flatness requirements are commensurate with those values disclosed above in conjunction with the embodiment of Figures 4. The process by which the desired flatness and surface quality of the flat outside surface of the manifold is obtained is also similar to the process described above in regard to the flat bottom surface of Figures 4 and 5.

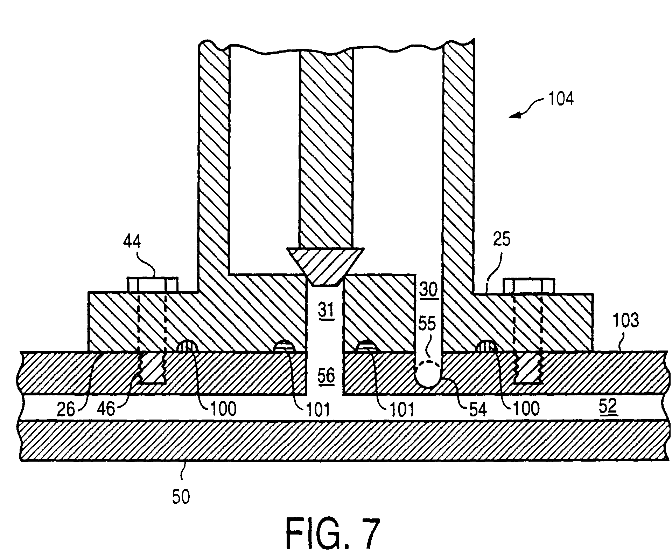

With reference to Figure 7, another embodiment of the present invention is shown wherein the flat bottom valve illustrated in Figures 3 and 5 is shown attached to a manifold 50 having a flat outside surface 103. As illustrated, manifold 50 includes a fluid passage 52 and inlet and outlet passages 55 and 56 that communicate with the inlet and outlet passages 30 and 31 of valve assembly 104. Manifold inlet passage 55 contains a through opening 54 extending through the width of manifold 50 that directs a fluid flow into the manifold. Manifold 50 also comprises threaded openings 46 disposed along flat outside surface 103. The valve assembly 104 and manifold 50 are attached by threaded fasteners 44. O-rings 100 and 101 are disposed within recesses 40 and 42, respectively, and form a seal at the valve/manifold interface when the two assemblies are attached. O-rings 100 and 101 may comprise a polymer, metal or any other material capable of forming a seal at the valve assembly and manifold interface. For example, polymer o-rings are well-suited for systems delivering a low temperature liquid, while metal o-rings are more appropriately used in high temperature, high pressure, corrosive applications. It is noted, that the manifold opening and recess dimensions and surface flatness requirements are commensurate with those values disclosed above in conjunction with the embodiment of Figure 5.

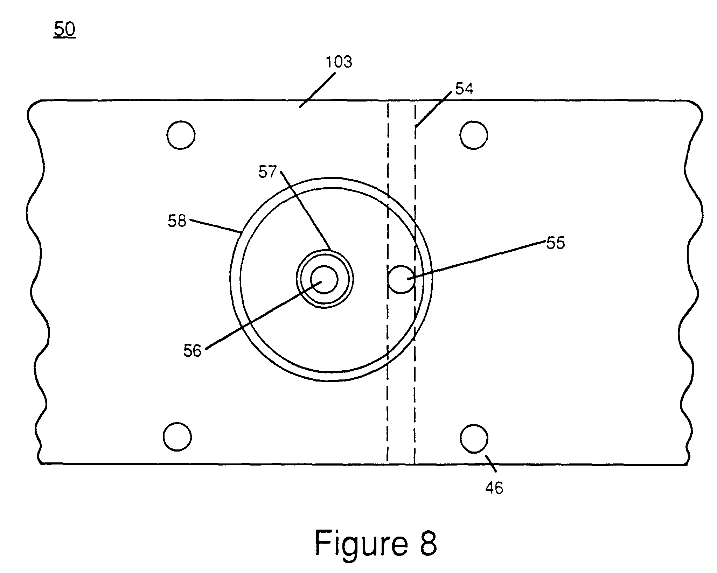

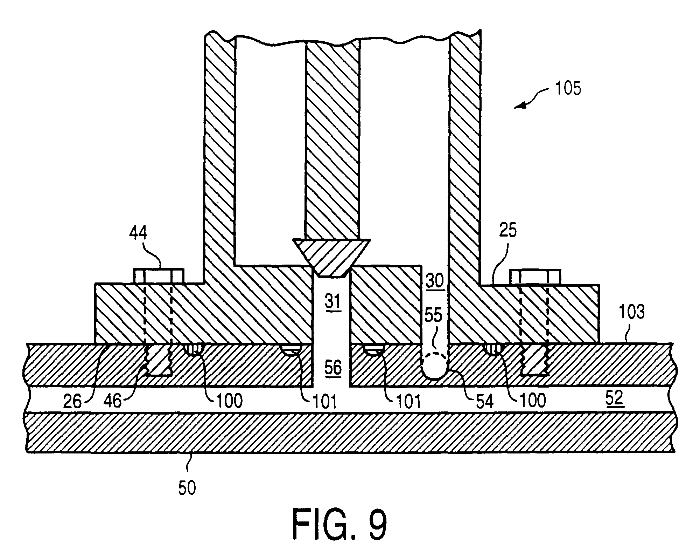

Figure 8 illustrates an alternative embodiment of the manifold depicted in Figure 7. In the embodiment of Figure 7, o-rings 100 and 101 are held in position by recesses 40 and 42 disposed within flat bottom surface 26 of valve assembly 104. In the embodiment of Figure 8, recesses 57 and 58 are provided within the flat outside surface 103 of manifold 50 to hold in position o-rings 100 and 101. Hence, in the embodiment of Figure 8, a flat bottom valve devoid of recesses 40 and 42 may be attached to manifold 50. (See Figure 4) With reference to Figure 9, the manifold of Figure 8 is shown having valve assembly 105 attached to flat outside surface 103. Note that o-rings 100 and 101 are disposed within recesses 57 and 58 and interface with valve assembly 105 along flat surface 26.

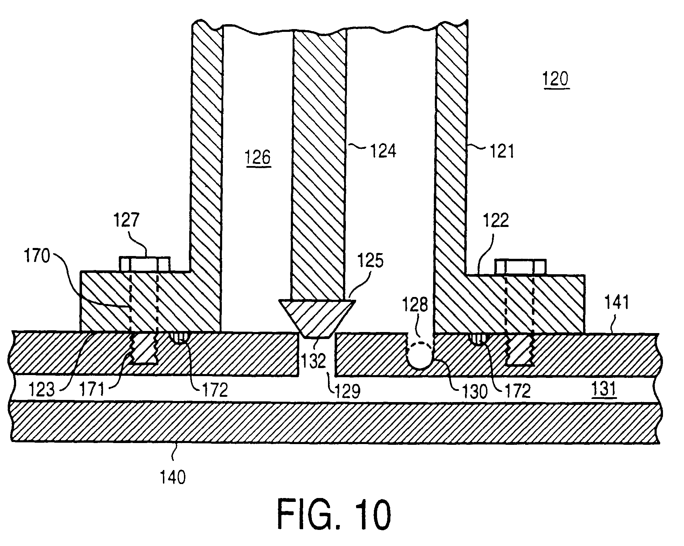

Figure 10 illustrates yet another embodiment of the present invention. As shown in Figure 10, a valve body assembly 120 is shown attached to a manifold 140 having a flat outside surface 141. Valve assembly 120 includes a cavity 126 defined by wall 121, and a flanged section 122 possessing through holes 170 and a flat bottom surface 123. Manifold 140 includes a fluid passage 131 and inlet and outlet passages 128 and 129, respectively. Manifold inlet passage 128 contains a through opening 130 extending at least partially through the width of manifold 140 to direct a fluid flow into the manifold. Manifold 140 also possesses an opening 132 for directing a fluid flow out of valve assembly cavity 126 into passage 129. As illustrated, assembly 120 includes a valve element 125 attached to a stem 124 to forcibly engage the valve element against manifold outlet opening 132. Note that manifold 140 also comprises threaded openings 171 disposed along flat outside surface 141. The valve body assembly 120 and manifold 140 are attached by threaded fasteners 127. A sealing device 172 is disposed between the valve body assembly and manifold to seal the interface between the two parts.

With continuing reference to Figure 10, note that valve assembly 120 does not itself possess inlet and outlet passages. Instead, the assembly of Figure 10 possesses only one set of passages that are integrally formed within manifold 140. The valve body assembly 120 and manifold 140 are configured in such a way that cavity 126 and valve element 125 are disposed above inlet and outlet passages 128 and 129. As previously discussed, when the valve body assembly 120 is attached to manifold 140, valve element 125 is positioned to engage with opening 132 to permit or restrict a fluid flow through passage 129. Although opening 132 is shown as integrally forming a valve seat within passage 129, it should be understood that a valve seat insert may be disposed within outlet passage 129.

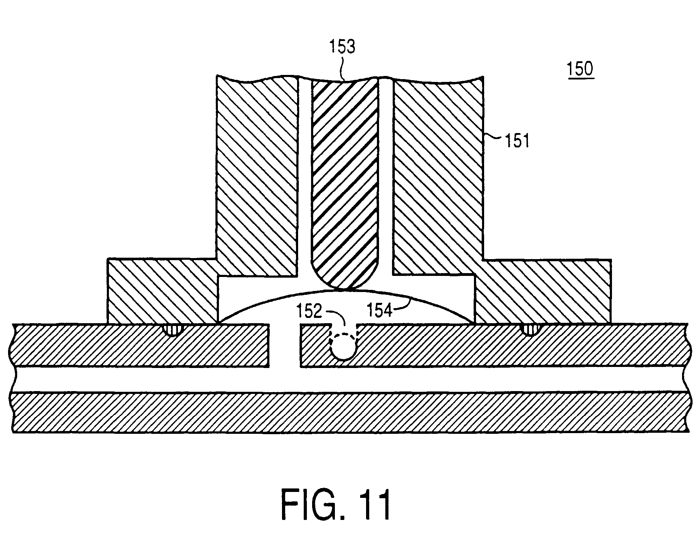

Figure 11 illustrates a variation to the embodiment disclosed in Figure 10. As shown, the assembly 150 comprises a body 151, a diaphragm 154 and plunger 153. A fluid flow passing through the assembly is controlled by forcibly engaging plunger 153 with diaphragm 154 so as to permit or restrict flow through opening 152.

Although a manifold has been described in the foregoing discussion, it is to be understood that any fluid delivery means comprising at least one substantially planar surface may be utilized in the implementation of the present invention. It is further understood that manifold 50 may comprise any material that meets the temperature, pressure and purity requirements of the particular application. It is desirable, however, to construct the manifold of a material that has a coefficient of thermal expansion that is similar to that of the valve assembly body.

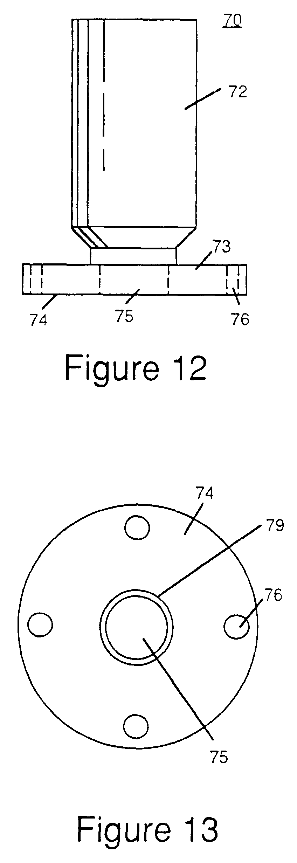

Figure 12 illustrates yet another embodiment of the present invention. Figure 12 represents an instrumentation device 70 having a flat bottom surface 74. Instrumentation device 70 includes a body 72 and a flanged portion 73 having opening 75 and through holes 76. Opening 75 provides a fluid inlet path to the body of the device. It is to be appreciated that a variety of different measurement devices may be housed within body 72. For example, if measurement device 70 comprises a pressure transducer, body 72 may include a capacitance manometer. Practitioners in the art will appreciate that a multitude of other measurement or sensing devices may also be used. Through openings 76 are provided to accommodate the means for securing the device to other components within a fluid delivery system.

Figure 13 illustrates a bottom view of the instrumentation device depicted in Figure 12. As noted above, the instrumentation device of the present invention possesses a flat bottom surface 74 containing an inlet opening 75 and through openings 76. Flat bottom surface 74 allows the instrumentation device 70 to be attached to a second system component (not shown) having a flat surface with a corresponding opening to communicate with inlet opening 75. Device 70 may be attached to an adjoining flat surface by inserting threaded fasteners (bolts) into through openings 76 and engaging the fasteners with threaded openings dispose within the adjoining flat surface. With continuing reference to Figure 13, recess 79 is shown disposed about opening 75. In accordance with the present invention, an o-ring, or other similar device, (not shown) is disposed within recess 79 to provide a seal at the interface between device 70 and a second fluid delivery system component.

In one embodiment, body 72 and flanged section 73 of device 70 comprises stainless steel. The size and shape of inlet opening 75 and through openings 76 can vary dramatically depending upon the particular fluid delivery system and instrumentation sensing device being used. In an embodiment wherein device 70 comprises a pressure transducer, opening 75 has a substantially circular cross-section with a diameter of approximately 0.75 inches. Through hole openings 76 also possess substantially circular cross-sections with diameters of approximately 0.2 inches. Recess 79 comprises a substantially circular cross-section with a depth of 0.05 inches and a width of approximately between 0.15 to 0.2 inches. The flatness and surface finish of surface 74 varies in accordance with the device and the particular sealing requirements. Typically, however, the flatness is controlled to approximately between 0.005 to 0.001 inches, wherein the surface finish is held to a 16 RA finish or better.

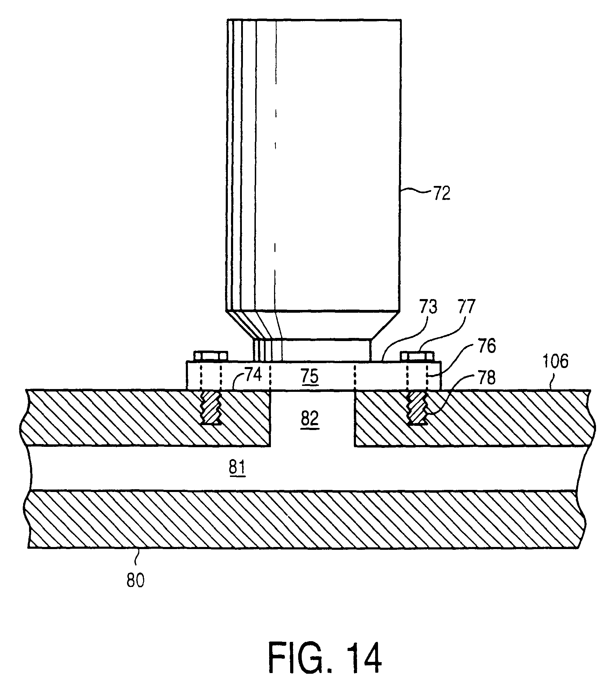

As previously discussed, and as illustrated in Figure 2, in a conventional fluid delivery system the instrumentation devices require fittings, and sometimes welds, to connect the devices to other components within the system. As illustrated in Figure 14, the instrumentation devices of the present invention may be attached to a manifold 80 or other components within a fluid delivery system without the use of fittings or welds. As shown in Figure 14, device 70 may be attached to a manifold 80 having a fluid passage 81 and an inlet passage 82 that communicates with inlet opening 75 of device 70. Manifold 80 also comprises a flat outside surface 106 and a plurality of threaded openings 78 corresponding through openings 76 of device 70. Device 70 is attached to manifold 80 by first placing an o-ring or other sealing device within recess 79 and aligning openings 75 and 76 with manifold openings 82 and 78. Once aligned, device 70 is attached to manifold 80 by inserting threaded fasteners 77 into through holes 76 and engaging the fasteners with the threaded openings 78.

Thus far, a number of embodiments of the present invention have been disclosed demonstrating the methodology of interconnecting flat bottom valves and instrumentation devices to a manifold having at least one flat outside surface. It is to be appreciated that flat bottom architecture, as it relates to fluid delivery systems, is not solely limited to valves and instrumentation devices. The methodology of the present invention may also be extended to a host of other devices including, but not limited to, filters, flow meters, etc..

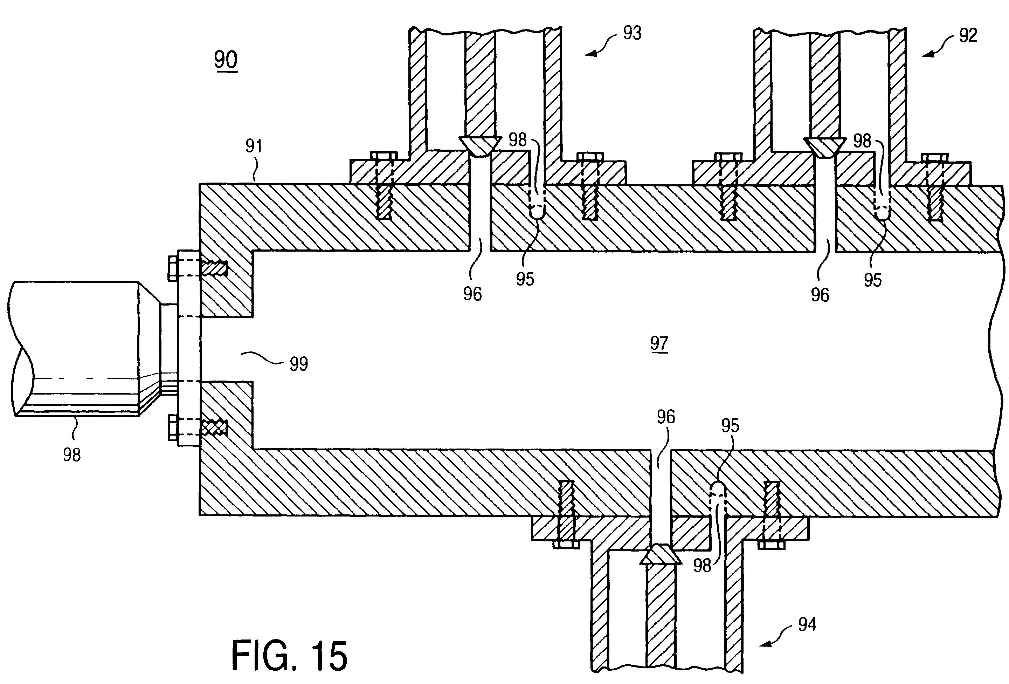

Figure 15 illustrates one manner of implementing the methodology of the present invention in a multi-component fluid delivery system. System 90 depicts a portion of a flat bottom architecture fluid delivery system that includes an instrumentation device 98 and valves 92, 93, and 94 disposed about the flat outside surfaces of manifold 91. The valves communicate with the manifold cavity 97 through passages 99 and 96, respectively. Manifold 91 also comprises inlet passages 98 that direct a fluid flow into valves 92, 93 and 94. In addition, the manifold inlet passages 98 contain through openings 95 that extend to the outer surfaces of manifold 91. Openings 95 are provided to direct a fluid flow into the manifold from an extemal source.

The advantages realized by using the flat bottom components and architecture of the present invention are readily apparent in the system depicted in Figure 15. Most notably, the system is devoid of fittings, welds, and extended lengths of tubing that are normally required to interconnect fluid system components. As a result, the contamination, corrosion, leakage and reliability problems associated with the prior art methods of interconnecting fluid system components are greatly diminished. It is also important to note that the components of system 91 may be attached and arranged along a plurality of flat manifold surfaces. This provides a large degree of flexibility in the design of fluid systems and ultimately allows for the miniaturization of such designs.

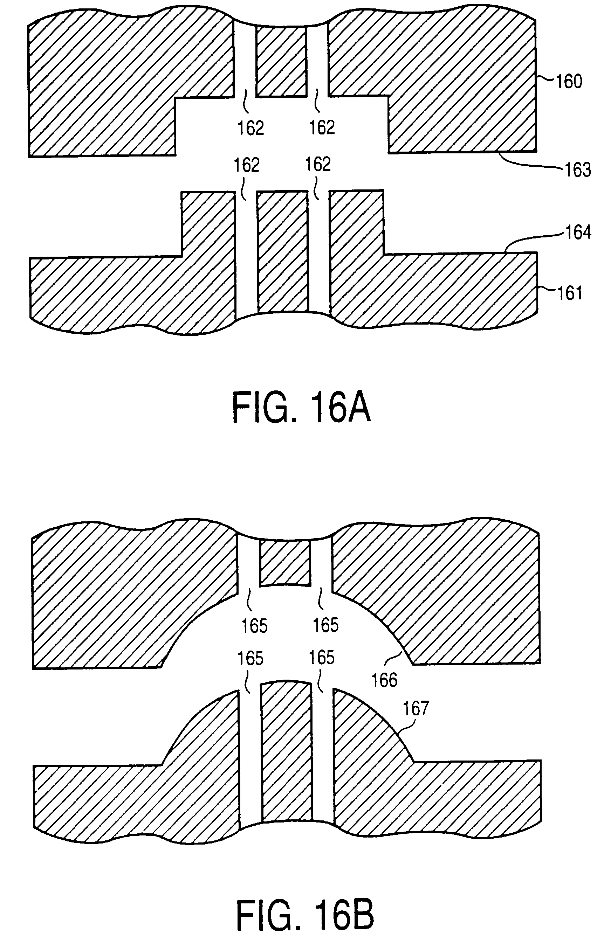

In the foregoing description fluid system components possessing planar mating surfaces have been discussed. However, it is understood that the present invention is not limited to fluid system components having only flat/planar interfacing surfaces. Figures 16a and 16b depict additional mating surface configurations that may be used in implementing the present invention. As illustrated in Figure 16a, the present invention may include two fluid system components 160 and 161 having fluid passages 162 disposed along stepped surfaces 163 and 164. Figure 16b illustrates yet another embodiment wherein fluid passages 165 are disposed along curved mating surfaces 166 and 167. It is important to note that Figures 16a and 16b are presented to illustrate only two of many non-planar embodiments that may be used in implementing the present invention. Moreover, it is noted that any non-planar embodiments, like those depicted in Figures 16a and 16b, should not include complex surfaces. Instead, the components should comprise relatively smooth surfaces that are easy to machine and minimize the probability of mismatching parts. As an example, jagged, threaded, or other complex surfaces are undesireable since there is an increased likelihood that scrapped parts will result from uncurable machining inaccuracies.

It is appreciated that the methods and apparatus of the present invention may be used in a variety of technologies. It is further understood that the relative dimensions, geometric shapes, materials and process techniques set forth within the specification are exemplary of the disclosed embodiments only. Whereas many alterations and modifications to the present invention will no doubt become apparent to a person ordinarily skilled in the art having read the foregoing description, it is to be understood that the particular embodiments shown and described by way of illustration are in no way intended to be limiting. Therefore, reference to the details of the illustrated diagrams is not intended to limit the scope of the claims which themselves recite only those features regarded as essential to the invention.

## Claims

1. An apparatus for delivering a fluid to a point-of-use location comprising:
a manifold having at least one passage to permit a fluid flow into and out of said manifold, at least one flat outside surface and at least one aperture for connecting said passage to said flat outside surface; and
at least one component comprising:
a planar surface for making intimate contact with said flat outside surface when said component is attached to said manifold; and
an opening for communicating with said aperture when said component is attached to said manifold.

2. The apparatus of claim 1 further comprising a sealing device disposed between said planar surface of said component and said flat outside surface of said manifold.

3. The apparatus of claim 1 further comprising a recess disposed about said opening of said component.

4. The apparatus of claim 3 wherein a sealing device is disposed between said recess of said component and said flat outside surface of said manifold.

5. The apparatus of claim 4 wherein said sealing device comprises an o-ring.

6. The apparatus of claim 1 wherein said component comprises a pressure transducer.

7. The apparatus of claim 1 wherein said flat bottom component comprises a valve.

8. A valve for interfacing with a fluid system component having a flat surface and a first and second opening disposed along said flat surface, said valve comprising:
a body defining a cavity, said body having a planar surface for interfacing with said flat outside surface of said fluid system component when said valve is attached to said fluid system component;
an inlet passage having a first and second port to permit said fluid flow into said cavity and an outlet passage having a third and fourth port to permit said fluid flow out of said cavity, said first and third ports being disposed along said planar surface of said body wherein each of said first and third ports communicate with one of said first and second openings of said fluid system component when said valve is attached to said fluid system component, said second and fourth ports opening into said cavity, said second port having a valve seat;
a valve element disposed within said cavity, away from said valve seat and adapted to engage said valve seat to thereby adjust said fluid flow through said second port; and
means operatively associated with said valve element for forcibly engaging said valve element with said valve seat.

9. The valve of claim 8 further comprising a first recess encircling said third port and a second recess encircling said first and third ports.

10. The valve of claim 9 wherein a first and second sealing device is disposed within said first and second recesses, respectively.

11. A valve for interfacing with a fluid system component having a fluid communication means disposed along a flat outer surface, said valve comprising:
means for directing a fluid flow into and out of said valve, said directing means having openings disposed along an outer planar surface for communicating with said communication means of said fluid system component when said valve is attached to said fluid system component.

12. The valve of claim 11 further comprising at least one recess encircling said openings for accommodating a sealing device.

13. An apparatus for delivering a fluid to a point-of-use location comprising:
a manifold having a plurality of passages to permit a fluid flow into and out of said manifold, at least one flat outside surface and a plurality of apertures for connecting said plurality of passages to flat outside surface; and
at least one valve comprising:
a body defining a cavity, said body having a planar surface for interfacing with said flat outside surface of said manifold when said valve is attached to said manifold;
an inlet passage having a first and second port to permit said fluid flow into said cavity and an outlet passage having a third and fourth port to permit said fluid flow out of said cavity, said first and third ports being disposed along said planar surface of said body wherein each of said first and third ports communicate with one of said plurality of apertures when said valve is attached to said manifold, said second and fourth ports opening into said cavity;
a valve element disposed within said cavity, away from said second port and adapted to engage said second port to thereby adjust said fluid flow through said second port; and
means operatively associated with said valve element for forcibly engaging said valve element with said second port.

14. The apparatus of claim 13 further comprising a plurality of through holes in said planar surface of said body, a plurality of threaded openings disposed within said flat outside surface of said manifold and a plurality of threaded fasteners disposed within said plurality of through holes for engaging said plurality of threaded openings to form a fluid seal between said planar surface of said valve and said flat outside surface of said manifold.

15. The apparatus of claim 13 and 14 wherein a sealing device is disposed between said planar surface of valve and said flat outside surface of said manifold.

16. The apparatus of claim 13 wherein said flat outside surface of said manifold includes a plurality of recesses disposed about said plurality of apertures.

17. The apparatus of claim 13 wherein said planar surface of said valve includes a plurality of recesses disposed about said first and third ports.

18. The apparatus of claim 16 wherein a sealing device is disposed within each of said recesses for sealing the interface between said plurality of apertures of said manifold and said first and third ports of said valve.

19. The apparatus of claim 17 wherein a sealing device is disposed within each of said recesses for sealing the interface between said first and third ports of said valve and said flat outside surface of said manifold.

20. The apparatus of claim 18 and 19 wherein said sealing device comprises at least one o-ring.

21. An apparatus for delivering a fluid to a point-of-use location comprising:
a manifold having a plurality of passages to permit a fluid flow into and out of said manifold, at least one flat outside surface having a plurality of threaded openings, said manifold further comprising a plurality of apertures for connecting said plurality of passages to said flat outside surface;
at least one valve comprising:
a body defining a cavity, said body having a planar surface and a plurality of through holes extending through said body to said planar surface;
an inlet passage having a first and second opening to permit said fluid flow into said cavity and an outlet passage having a third and fourth opening to permit said fluid flow out of said cavity, said first and third openings being disposed along said planar surface of said body such that each of said first and third openings communicate with one of said plurality of apertures when said valve is attached to said manifold, said second and fourth openings being disposed along said second inner wall, said second opening possessing a valve seat;
a valve element disposed within said cavity, away from said valve seat and adapted to engage said valve seat to thereby adjust said fluid flow through said second opening;
means operatively associated with said valve element for forcibly engaging said valve element with said valve seat; and
a plurality of threaded fasteners disposed within said plurality of through holes of said valve for engaging said plurality of threaded openings of said manifold to form a fluid seal between said planar surface of said valve body and said flat outside surface of said manifold.

22. The apparatus of claim 21 wherein a sealing device is disposed between said planar surface of said valve and said flat outside surface of said manifold.

23. The apparatus of claim 22 wherein said sealing device comprises a metal gasket.

24. The apparatus of claim 22 wherein said sealing device comprises at least one o-ring.

25. The apparatus of claim 21 wherein said flat outside surface of said manifold includes a plurality of recesses disposed about said plurality of apertures.

26. The apparatus of claim 21 wherein said planar surface of said valve includes a plurality of recesses disposed about said first and third openings.

27. The apparatus of claim 25 wherein a sealing device is disposed within each of said recesses for sealing the interface between said plurality of apertures of said manifold and said first and third openings of said valve.

28. The apparatus of claim 26 wherein a sealing device is disposed within each of said recesses for sealing the interface between said first and third openings of said valve and said flat outside surface of said manifold.

29. The apparatus of claim 27 and 28 wherein said sealing device comprises at least one o-ring.

30. An improved apparatus for delivering a fluid to a point-of-use location comprising:
a manifold having a plurality of passages to permit a fluid flow into and out of said manifold, at least one flat outside surface and a plurality of inlet and outlet ports for connecting said plurality of passages to said flat outside surface, said flat outside surface having a plurality of threaded openings and a plurality of recesses wherein each of said of recesses is disposed about said inlet and outlet ports;
at least one valve comprising:
a body defining a cavity, said body including a flat surface and a plurality of through holes extending through said body to said flat surface;
an inlet passage having a first and second opening to permit said fluid flow into said cavity and an outlet passage having a third and fourth opening to permit said fluid flow out of said cavity, said first and third openings being disposed along said planar surface of said body, each of said first openings communicating with one of said inlet ports of said manifold, each of said third openings communicating with one of said outlet ports of said manifold, said second and fourth openings being disposed along said second inner wall, said second opening having a valve seat;
a valve element disposed within said cavity, away from said valve seat and adapted to engage said valve seat to thereby adjust said fluid flow through said second opening;
means operatively associated with said valve element for forcibly engaging said valve element with said valve seat;
sealing means disposed within each of said recesses of said manifold; and
a plurality of threaded fasteners disposed within said plurality of holes of said valve for engaging said plurality of threaded openings of said manifold such that a fluid seal is formed between said planar surface of said valve and said flat outside surface of said manifold.

31. The apparatus of claim 30 wherein said sealing means comprises at least one o-ring.

32. An improved apparatus for delivering a fluid to a point-of-use location comprising:
a manifold having an inlet passage and an outlet passage to permit a fluid flow into and out of said manifold, at least one flat outside surface and an inlet and outlet port for connecting said inlet and outlet passages to said flat outside surface;
at least one valve body assembly comprising:
a body defining a cavity, said body including a flange having a planar surface for interfacing with said flat outside surface of said manifold when said valve body assembly is attached to said manifold;
a valve element disposed within said cavity and adapted to engage said inlet or outlet port of said manifold to thereby adjust said fluid flow through said inlet or outlet port; and
means operatively associated with said valve element for forcibly engaging said valve element with said inlet or outlet port.

33. The apparatus of claim 32 further comprising a means for sealing the interface between said planar surface of said flange and said flat outside surface of said manifold.

34. The apparatus of claim 33 wherein said sealing means comprises a polymer seal.

35. The apparatus of claim 33 wherein said sealing means comprises a metal seal.

36. A valve for interfacing with a fluid system component having a first mating surface and a first and second opening disposed along said first mating surface, said valve comprising:
a body defining a cavity, said body having a second mating surface for interfacing with said first mating surface of said fluid system component when said valve is attached to said fluid system component;
an inlet passage having a first and second port to permit said fluid flow into said cavity and an outlet passage having a third and fourth port to permit said fluid flow out of said cavity, said first and third ports being disposed along said first mating surface of said body wherein each of said first and third ports communicate with one of said first and second openings of said fluid system component when said valve is attached to said fluid system component, said second and fourth ports opening into said cavity, said second port having a valve seat;
a valve element disposed within said cavity, away from said valve seat and adapted to engage said valve seat to thereby adjust said fluid flow through said second port; and
means operatively associated with said valve element for forcibly engaging said valve element with said valve seat.

37. An apparatus for delivering a fluid to a point-of-use location comprising:
a manifold having a plurality of passages to permit a fluid flow into and out of said manifold, a first mating surface and a plurality of apertures for connecting said plurality of passages to said first mating surface; and
at least one valve comprising:
a body defining a cavity, said body having a second mating surface for interfacing with said first mating surface of said manifold when said valve is attached to said manifold;
an inlet passage having a first and second port to permit said fluid flow into said cavity and an outlet passage having a third and fourth port to permit said fluid flow out of said cavity, said first and third ports being disposed along said second mating surface of said body wherein each of said first and third ports communicate with one of said plurality of apertures when said valve is attached to said manifold, said second and fourth ports opening into said cavity;
a valve element disposed within said cavity, away from said second port and adapted to engage said second port to thereby adjust said fluid flow through said second port; and
means operatively associated with said valve element for forcibly engaging said valve element with said second port.

38. The apparatus of claim 37 further comprising a plurality of holes in said second mating surface of said body, a plurality of threaded openings disposed within said first mating surface of said manifold and a plurality of threaded fasteners disposed within said plurality of holes for engaging said plurality of threaded openings to form a fluid seal between said first and second mating surfaces.

39. The apparatus of claim 37 and 38 wherein a sealing device is disposed between said first and second mating surfaces.

40. The apparatus of claim 37 wherein said first mating surface of said manifold includes a plurality of recesses disposed about said plurality of apertures.

41. The apparatus of claim 37 wherein said second mating surface of said valve includes a plurality of recesses disposed about said first and third ports.

42. The apparatus of claim 40 wherein a sealing device is disposed within each of said recesses for sealing the interface between said plurality of apertures of said manifold and said first and third ports of said valve.

43. The apparatus of claim 41 wherein a sealing device is disposed within each of said recesses for sealing the interface between said first and third ports of said valve and said first mating surface of said manifold.

44. The apparatus of claim 42 and 43 wherein said sealing device comprises at least one o-ring.
